# EUROPEAN PATENT APPLICATION

(11) **EP 4 841 676 A1**
(43) Date of publication of application: **18.11.2026**
(21) Application number: 24916265.2
(22) Date of filing: 11.05.2024
(51) Int. Cl.: H01L 23/488, C25D 7/12, H10H 20/857, H01L 25/065, C25D 3/48, H01L 23/482, H01L 21/48

(54) **GOLD-SILVER ALLOY BUMP, AND PREPARATION METHOD THEREFOR AND APPLICATION THEREOF**

(30) Priority: 10.01.2024 CN 202410033246
(71) Applicant: Shenzhen United Blue Ocean Applied Materials Technology Co., Ltd, Shenzhen, Guangdong 518020 (CN)
(72) Inventor: REN, Zhangyou, Shenzhen, Guangdong 518020 (CN); WANG, Tong, Shenzhen, Guangdong 518020 (CN); DENG, Chuan, Shenzhen, Guangdong 518020 (CN); LIU, Song, Shenzhen, Guangdong 518020 (CN); DENG, Wei, Shenzhen, Guangdong 518020 (CN)
(74) Representative: Bandpay & Greuter
(86) International application number: PCT/CN2024/092666
(87) International publication number: WO 2025/148209

(57) **Abstract**

Disclosed are a gold-silver alloy bump, and a fabrication method and application thereof, which belong to the technical field of semiconductor flip-chip packaging. The gold-silver alloy bump consists of two gold-silver alloy layers, namely a bonding layer and a protective layer, respectively. A gold content of the bonding layer is 20 wt% to 50 wt%. A thickness of the protective layer is much less than that of the bonding layer, with a gold content of 60 wt% or above. The gold-silver alloy bump provided by the present disclosure has equivalent hardness, roughness and sulfidation resistance to a pure gold bump, can satisfy a technical requirement of packaging of a flip chip, and meanwhile can greatly reduce cost. Through the method of the gold-silver alloy bump according to the present disclosure, the double-layer structured gold-silver alloy bump of the present disclosure can be obtained through a same device and plating solution by only changing a current density. In this way, a fabrication process is simplified, production efficiency is improved, and production cost is reduced.

## Description

### BACKGROUND OF THE INVENTION

### 1. Technical Field

The present disclosure belongs to the technical field of semiconductor flip-chip packaging, and relates to a gold-silver alloy bump, and a fabrication method and application thereof.

### 2. Description of Related Art

The flip-chip packaging technology interconnects a component face-down directly to a substrate, carrier or circuit board through a bump on a chip. A flip chip eliminates a redundant packaging process, and features a reduced size, high-frequency operation, a low parasitic effect, and a high input/output (I/O) density. The flip-chip packaging technology is applicable to various chips for liquid crystal display, image sensors, memories, microprocessors, and microwave radio frequency. Typical application products include a mobile phone, a television, a computer, a tablet computer, and a camera.

A bump used in the flip chip is generally made of pure gold due to excellent properties of gold, to guarantee chip performance. As another precious metal, silver also possesses superior electrical and thermal conductivity, and is much cheaper than the gold. However, a bump made of pure silver has problems such as silver whiskers, silver migration, and susceptibility to oxidation and sulfidation, thus failing to satisfy chip performance requirements. Partial replacement of gold with silver can greatly reduce the cost of gold bumps. In addition, compared with a pure gold bump, a gold-silver alloy bump features lower electrical resistance and higher thermal conductivity, facilitating improvement in heat dissipation performance of a chip and increase in an electrical interconnection density. However, using an electroplating process to fabricate a gold-silver alloy bump as a substitute for a gold bump still has the following technical problems to be solved.

First, hardness of the annealed gold-silver alloy bump needs to match that of an annealed pure gold bump. In Chip-on-Film (COF) packaging, a bump needs to be directly bonded by compression to a copper circuit on a polyimide film through a solder layer, so hardness of the bump cannot be excessively high, and is generally required to be 45 HV to 75 HV after annealing. Otherwise, the bump may cause cracking of a conductive circuit. In Chip-on-Glass (COG) packaging, the bump is connected to a copper circuit on a glass substrate through an anisotropic conductive film. Thus, the bump needs to possess sufficient hardness to facilitate compression bonding of the anisotropic conductive film, with the hardness generally required to be in a range of 75 HV to 105 HV. Second, compared with gold, a surface of silver is prone to sulfidation in air. Once sulfides are formed, bonding performance to tin solder or the anisotropic conductive film may deteriorate, which may affect electrical connection of silver and copper circuits. Thus, it is necessary to improve sulfidation resistance of a gold-silver alloy bump. Finally, surface roughness of the bump after electroplating should not be excessively high, and the required roughness Rₐ is generally less than 100 nm. The excessively high roughness may adversely affect electrical interconnection to the copper circuit.

The invention patent with the publication number CN104099653B discloses a semiconductor structure and a manufacturing method therefor, and specifically discloses a silver alloy electroplating solution for fabricating a silver alloy bump. The electroplating solution includes potassium silver cyanide, and/or potassium gold cyanide and potassium palladium cyanide, and pH of the electroplating solution is controlled within a range of 6 to 8. The electroplating solution further includes a small amount of oxalate. As is well known, silver ions are photosensitive substances. Without a stabilizer for the silver ions, metallic silver may be rapidly precipitated from the electroplating solution. It indicates that the electroplating solution is unstable.

This invention patent further discloses three structures for replacing a pure gold bump with a silver alloy bump. The first structure uses a silver alloy bump body to directly replace a gold bump. As a silver alloy or its partial surface lacks oxidation resistance and sulfidation resistance, reliability risks may arise later due to oxidation or sulfidation of silver. In particular, the patent specifies that the silver alloy bump is silver-dominated, and an atomic ratio of gold needs to be controlled as 25% or below. The second structure is a laminated structure. Firstly, a silver alloy bump is fabricated, and then a gold bump structure having a certain thickness is formed on a top surface of the silver alloy bump. The fabrication of metal, such as pure gold, on the top surface requires a second electroplating solution and a related apparatus, which increases process complexity and device cost. The third structure is an enclosure structure. A silver alloy bump is fabricated first, and then a metal enclosure layer is formed on top and side surfaces of the silver alloy bump through electroplating or electroless plating. Compared with pure gold, a silver alloy is susceptible to oxidation and sulfidation, so the first or second structure still has defects. Although the third structure solves oxidation and sulfidation problems of the silver alloy through a gold enclosure structure, the process requires two rounds of photoresist exposure and development, and two different electroplating solutions, thus increasing process complexity and cost.

The invention patent with the publication number CN101225536B discloses a gold-silver alloy electroplating solution. The electroplating solution is composed of potassium gold cyanide having a gold content of 1 g/L to 30 g/L, potassium silver cyanide having a silver content of 1 ppm to 200 ppm, potassium pyrophosphate of 30 g/L to 100 g/L, boric acid of 20 g/L to 50 g/L, and 0.05 g/L to 150 g/L of ethylenediamine, ethylenediaminetetraacetic acid, diethylenetriamine, triethylenetetramine, tetraethylenepentamine or pentaethylenehexamine. An electroplated gold-silver alloy includes 0.3 wt% to 2.0 wt% of silver, and has hardness of 150 HV to 200 HV. This patent is mainly used for connector application and is not suitable for fabrication of a flip chip bump.

The invention patent with the publication number CH412508 discloses an electroplating solution for fabricating a gold-silver alloy. In addition to potassium gold cyanide and potassium silver cyanide, the electroplating solution includes 60 g/L of potassium cyanide. Excess free cyanides may give rise to plating penetration and swelling of photoresist, thus damaging a bump structure. Meanwhile, a great amount of free cyanides are inconducive to environmental protection.

### BRIEF SUMMARY OF THE INVENTION

### Technical Problems

A primary objective of the present disclosure is to provide a gold-silver alloy bump. Through intensive research, the inventors optimize a structure design of the gold-silver alloy bump, improve a gold-silver ratio, and regulate a grain size in a gold-silver alloy. In this way, the obtained gold-silver alloy bump retains excellent electrical conductivity and thermal conductivity of the gold-silver alloy, and meanwhile, hardness, sulfidation resistance, surface roughness and other properties of the gold-silver alloy bump all satisfy technical requirements for packaging of a flip chip. Thus, the gold-silver alloy bump replaces a pure gold bump, to greatly reduce bump cost. The objective is achieved through the following specific technical solution.

### Technical Solution

A gold-silver alloy bump is provided. The gold-silver alloy bump consists of two gold-silver alloy layers, namely a bonding layer and a protective layer, respectively. A gold content of the bonding layer is 20 wt% to 50 wt%. A gold content of the protective layer is 60 wt% or above. An overall shape and size of the gold-silver alloy bump are consistent with those of a conventional pure gold bump for packaging of a flip chip.

Further, an average grain diameter of the gold-silver alloy layers is 0.10 µm to 0.30 µm. A grain size in the gold-silver alloy layers may be measured through an electron back scattered diffraction (EBSD) method, or another feasible method.

The inventors find through extensive exploration that annealing hardness and roughness of the gold-silver alloy bump are closely correlated with a gold content and a grain size of a gold-silver alloy. When the gold content is 20 wt% to 50 wt% and the average grain diameter is 0.10 µm to 0.30 µm, the annealing hardness of the gold-silver alloy bump is in a range of 45 HV to 105 HV, and coating roughness Rₐ is less than 100 nm, such that requirements of flip chip packaging for bump hardness and roughness can be satisfied. Sulfidation resistance of the gold-silver alloy bump can satisfy the requirements of flip chip packaging only when the gold content in the gold-silver alloy is 60 wt% or above. In view of this, the inventors propose the above gold-silver alloy bump composed of two layers of gold-silver alloys. The bonding layer is connected to a substrate, a carrier, or a circuit board. A specific gold content and grain size of the gold-silver alloy layers enable the bump to satisfy requirements in terms of hardness and roughness. The protective layer increases the gold content to 60 wt% or above, such that overall sulfidation resistance of the bump satisfies requirements. Meanwhile, a thickness of the protective layer is far less than that of the bonding layer, exerting almost no influence on overall hardness and roughness of the bump.

Further, a gold content in a gold-silver alloy of the bonding layer is 20 wt% to 40 wt%, such that hardness of the bonding layer is 45 HV to 75 HV, and requirements of Chip-on-Film (COF) packaging are satisfied.

Further, the gold content in the gold-silver alloy of the bonding layer is 30 wt% to 50 wt%, such that the hardness of the bonding layer is 75 HV to 105 HV, and requirements of Chip-on-Glass (COG) packaging are satisfied.

Further, a thickness of the bonding layer is 7 µm to 20 µm, and the thickness of the protective layer is 10 nm to 500 nm.

Another objective of the present disclosure is to provide a fabrication method for a gold-silver alloy bump. Through optimization of composition of an electroplating solution, different gold contents may be obtained only by adjusting a current density in the same electroplating solution. In this way, a double-layer structured gold-silver alloy bump of the present disclosure may be obtained in the same device without changing the electroplating solution, which simplifies a fabrication process, improves production efficiency, and reduces production cost. The objective is achieved through the following specific technical solution.

A fabrication method for a gold-silver alloy bump includes the following steps:
S1, pretreating a to-be-packaged chip, and preparing an electroplating solution, where the electroplating solution includes the following components: potassium gold cyanide (KAu(CN)₂), potassium silver cyanide (KAg(CN)₂), potassium pyrophosphate, and hydantoin, with a pH value of 8 to 10;
S2, putting the to-be-packaged chip into the electroplating solution obtained in S1, performing electroplating at a low current density, and fabricating a bonding layer of the gold-silver alloy bump;
S3, using the same electroplating solution and device to perform electroplating at a high current density, and fabricating a protective layer of the gold-silver alloy bump;
S4, removing an auxiliary material of the to-be-packaged chip; and
S5, performing annealing on the gold-silver alloy bump.

Further, in S2, the low current density is 0.3 A/dm² to 0.6 A/dm² (ampere per square decimeter (ASD)), and electroplating time is 30 min to 60 min.

Further, in S3, the high current density is 1.1 ASD to 1.3 ASD, and electroplating time is 20 s to 40 s.

Further, in S4, the removing an auxiliary material of the to-be-packaged chip includes removing photoresist on the to-be-packaged chip through a photoresist stripper, removing a gold seed layer on a silicon substrate of the to-be-packaged chip through an etchant, and removing a titanium-tungsten (TiW) layer on the silicon substrate of the to-be-packaged chip. The photoresist stripper is N-methylpyrrolidone. The etchant is a thiourea solution. A substance for removing the titanium-tungsten layer is an H₂O₂ solution. Compared with a conventional iodine/potassium iodide etchant, the thiourea solution removes the gold seed layer without etching the gold-silver alloy bump.

Further, in S5, an annealing temperature is 270°C to 300°C, and annealing time is 5 min to 60 min.

Yet another objective of the present disclosure is to provide application of the gold-silver alloy bump. The gold-silver alloy bump is used for packaging of a flip chip.

Further, the flip chip includes a chip for liquid crystal display, an image sensor, a memory, a microprocessor, or microwave radio frequency.

Still another objective of the present disclosure is to provide a gold-silver alloy bump obtained through the fabrication method provided by the present disclosure, and application of the gold-silver alloy bump. The gold-silver alloy bump is used for packaging of a flip chip.

Further, the flip chip includes a chip for liquid crystal display, an image sensor, a memory, a microprocessor, or microwave radio frequency.

### Beneficial Effects

The present disclosure has the following beneficial technical effects: The gold-silver alloy bump provided by the present disclosure has equivalent hardness, roughness and sulfidation resistance to a pure gold bump, can satisfy a technical requirement of packaging of a flip chip, and meanwhile can greatly reduce cost. Through the fabrication method for the gold-silver alloy bump according to the present disclosure, the double-layer structured gold-silver alloy bump of the present disclosure can be obtained through the same device and plating solution by only changing a current density. In this way, a fabrication process is simplified, production efficiency is improved, and the production cost is reduced.

### BRIEF DESCRIPTION OF THE SEVERAL VIEWS OF THE DRAWINGS

FIG. 1 is a graph showing a relationship between a gold content and annealing hardness in a gold-silver alloy;
FIG. 2 is a graph showing a relationship between a gold content and coating roughness in a gold-silver alloy;
FIG. 3 and FIG. 4 are photographs showing compatibility between an electroplating solution and photoresist;
FIG. 5 and FIG. 6 are scanning electron microscope images of a gold-silver alloy bump after photoresist removal;
FIG. 7 shows EBSD crystal structure analysis results of Embodiment 1 and Embodiment 2;
FIG. 8 is a graph showing sulfidation resistance of a gold-silver alloy having different gold contents; and
FIG. 9 is a schematic flowchart of a fabrication method for a gold-silver alloy bump according to the present disclosure.

### DETAILED DESCRIPTION OF THE INVENTION

The technical solution of the present disclosure will be clearly and completely described below with reference to drawings of the description. Obviously, the implementations described are merely some implementations rather than all implementations of the present disclosure. Based on the implementations of the present disclosure, all other implementations obtained by those of ordinary skill in the art without making creative efforts shall fall within the protection scope of the present disclosure.

In the description of the present disclosure, it should be understood that orientations or positional relationships indicated by the terms "center", "longitudinal", "lateral", "upper", "lower", "front", "rear", "left", "right", "vertical", "horizontal", "top", "bottom", "inside", "outside", etc. are based on the orientations or positional relationships shown in the accompanying drawings and are merely for facilitating the description of the present disclosure and simplifying the description, rather than indicating or implying that an apparatus or element referred to necessarily has a particular orientation or is constructed and operated in a particular orientation, and therefore will not be interpreted as limiting the present disclosure. In addition, the terms "first" and "second" are for descriptive purposes only and should not be construed as indicating or implying relative importance, a quantity, or a position.

In the description of the present disclosure, it should be noted that unless expressly specified and defined otherwise, the terms "mount", "connect", and "connection" are to be construed broadly. For example, they can denote fixed connection, detachable connection, or integral connection; denote mechanical connection or electric connection; denote direct connection or indirect connection through an intermediate medium; or denote communication between interiors of two elements. For those of ordinary skill in the art, specific meanings of the terms in the present disclosure may be understood according to specific circumstances.

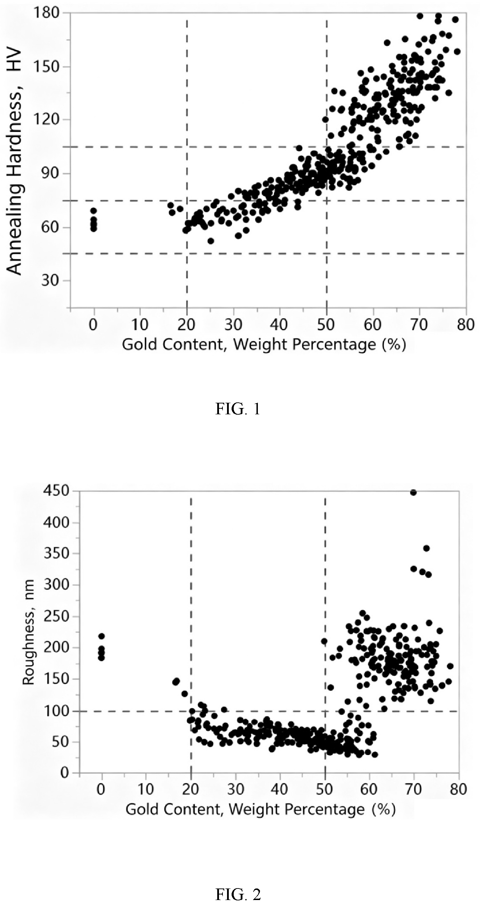

The inventors systematically study a relationship between a gold content and annealing hardness in a gold-silver alloy. As shown in FIG. 1, it can be seen that when the gold content in the gold-silver alloy is 20 wt% to 50 wt%, the annealing hardness is in a range of 45 HV to 105 HV, which satisfies a bump hardness requirement of packaging of a flip chip.

The inventors systematically study a relationship between a gold content and roughness in a gold-silver alloy. As shown in FIG. 2, it can be seen that when the gold content in the gold-silver alloy is 20 wt% to 50 wt%, the roughness is 100 nm or below, which satisfies a roughness requirement of packaging of a flip chip.

As shown in FIG. 1 and FIG. 2, not all gold-silver alloy ratios satisfy hardness and roughness requirements of packaging of a flip chip. When the gold content by weight is 50 wt% or above, hardness of the gold-silver alloy after annealing may exceed 105 HV. Meanwhile, when the gold content by weight is less than 20 wt% or greater than 50 wt%, coating roughness Ra is higher than 100 nm. Thus, the gold content by weight in the qualified gold-silver alloy bump needs to be in a range of 20 wt% to 50 wt%. In FIG. 1, operating ranges for low-hardness (45 HV to 75 HV) and high-hardness (75 HV to 105 HV) gold-silver alloys are further divided, and are suitable for Chip-on-Film (COF) and Chip-on-Glass (COG) packaging, respectively. It can be seen that the gold content by weight for electroplating of the low-hardness gold-silver alloy should be controlled within 20% to 40%, and the gold content by weight for electroplating of the high-hardness gold-silver alloy should be controlled within 30% to 50%. As the annealing hardness is affected by an annealing temperature and annealing time, a gold-silver alloy bump having a gold content of 30% to 40% may be caused to satisfy a requirement of COF or COG packaging by adjusting the annealing hardness through an annealing condition.

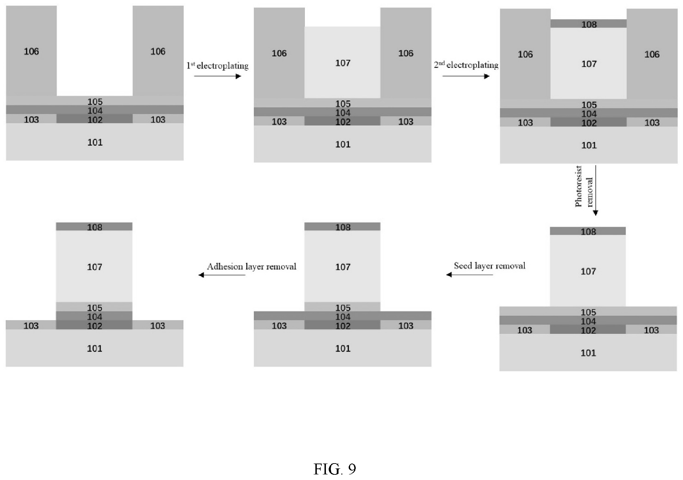

A flow of a fabrication method for a gold-silver alloy bump of the present disclosure is shown in FIG. 9. A structure of a to-be-packaged chip includes a silicon substrate transistor layer 101, an aluminum electrode 102, a passivation layer 103, a titanium-tungsten (TiW) adhesion layer 104, a gold seed layer 105, and photoresist 106. The to-be-packaged chip is put into an electroplating solution for first electroplating at a low current density for a long time, to obtain a bonding layer gold-silver alloy layer 107, and then undergoes second electroplating at a high current density for a short time, to obtain a protective layer gold-silver alloy layer 108. The electroplating solution has components and concentration as follows: potassium gold cyanide of 6 g/L to 10 g/L, potassium silver cyanide of 4 g/L to 7 g/L, potassium pyrophosphate of 50 g/L to 70 g/L, and hydantoin of 20 g/L to 40 g/L, with a pH value of 8 to 10. The bonding layer gold-silver alloy layer 107 has a thickness of 7 µm to 20 µm and a gold content of 20 wt% to 50 wt%. The protective layer gold-silver alloy layer 108 has a thickness of 10 nm to 500 nm and a gold content of 60 wt% or above. An average equivalent circle diameter of grains measured by an electron back scattered diffraction (EBSD) method is 0.10 µm to 0.30 µm. After electroplating, the photoresist 106 on the to-be-packaged chip is removed through n-methyl-2-pyrrolidone (NMP) as a photoresist stripper, the gold seed layer 105 on a silicon substrate of the to-be-packaged chip is removed through an etchant, and the TiW layer 104 on the silicon substrate of the to-be-packaged chip is removed through a H₂O₂ solution. Finally, annealing is performed on the gold-silver alloy bump, where an annealing temperature is 270°C to 300°C, and annealing time is 5 min to 60 min.

### Embodiment 1

A low-hardness gold-silver alloy bump is fabricated through the following steps.

S1, a to-be-packaged chip is pretreated, and an electroplating solution is prepared and includes the following components: potassium gold cyanide of 6 g/L, potassium silver cyanide of 7 g/L, potassium pyrophosphate of 60 g/L, and hydantoin of 30 g/L, with a pH value of 9 at a temperature of 30°C.

S2, the to-be-packaged chip is put into the electroplating solution obtained in S1, electroplating is performed at a low current density, and a gold-silver alloy of a bonding layer of the gold-silver alloy bump is fabricated. The current density is 0.4 ASD, electroplating is performed for 45 min, an electroplating height is 10 µm, a gold content is 30 wt%, and roughness Ra is 65 nm.

S3, a same electroplating solution and device are used to perform electroplating at a high current density, and a gold-silver alloy of a protective layer of the gold-silver alloy bump is fabricated. The current density is 1.2 ASD, and electroplating time is 30 s. A gold-silver thickness of the layer is 200 nm, a gold content is 67 wt%, and overall roughness of the gold-silver alloy bump is 74 nm.

S4, photoresist of the to-be-packaged chip is removed through a photoresist stripper.

S5, a gold seed layer on a silicon substrate of the to-be-packaged chip is removed through an etchant.

S6, a TiW layer on the silicon substrate of the to-be-packaged chip is removed.

S7, annealing is performed on the gold-silver alloy bump, where an annealing temperature is 290°C, annealing time is 30 min, and hardness of the gold-silver alloy bump after annealing is 65 HV.

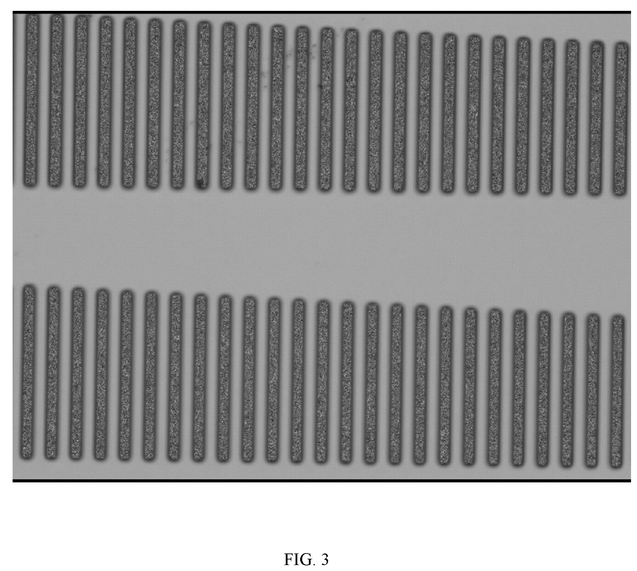

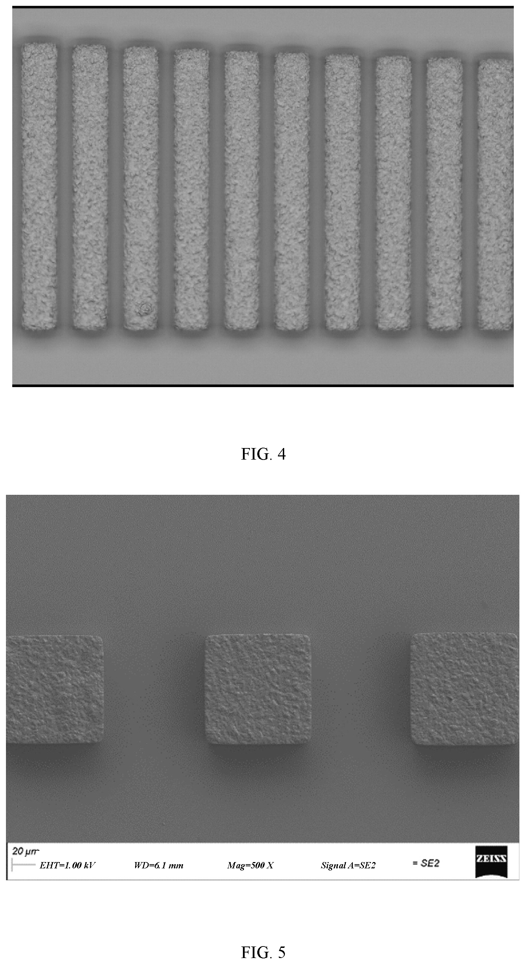

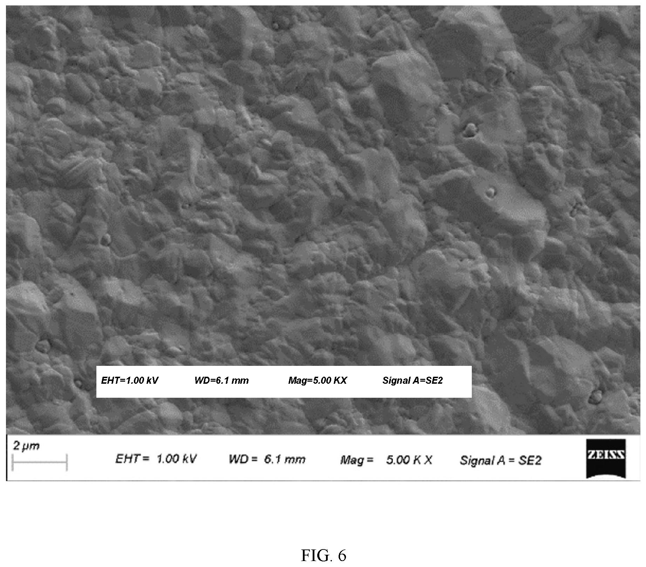

A pH value of an electroplating solution for a pure gold bump is generally controlled within a range of 5 to 7, and pH of an electroplating solution for the gold-silver alloy in the present disclosure is controlled within a range of 8 to 10. At high pH, photoresist may swell or exhibit reduced adhesion to a substrate, resulting in plating penetration, thus affecting circuit manufacturing precision. As shown in FIG. 3 (at a magnification of 200) and FIG. 4 (at a magnification of 500), a width of the gold-silver alloy bump is 20 µm, a width of the photoresist (JSRTHB-126N) between bumps is 8 µm, and an electroplating height is 10 µm. No plating penetration or photoresist swelling is observed with a gold-silver electroplating solution of the present disclosure. FIG. 5 and FIG. 6 show the gold-silver alloy bump fabricated by the present disclosure. After photoresist removal with NMP, a surface of the gold-silver alloy bump becomes smooth and uniform in crystallization, without formation of coarse crystals that cause excessively high local roughness.

### Embodiment 2

A high-hardness gold-silver alloy bump is fabricated through the following steps.

S1, a to-be-packaged chip is pretreated, and an electroplating solution is prepared and includes the following components: potassium gold cyanide of 10 g/L, potassium silver cyanide of 4 g/L, potassium pyrophosphate of 60 g/L, and hydantoin of 30 g/L, with a pH value of 9 at a temperature of 30°C.

S2, the to-be-packaged chip is put into the electroplating solution in S1, electroplating is performed at a low current density, and a bonding layer of the gold-silver alloy bump is fabricated. The current density is 0.5 ASD, electroplating is performed for 36 min, an electroplating height is 10 µm, a gold content is 42 wt%, and roughness Ra is 71 nm.

S3, a same electroplating solution and device are used to perform electroplating at a high current density, and a protective layer of the gold-silver alloy bump is fabricated. The current density is 1.2 ASD, and electroplating time is 20 s. A gold-silver thickness of the layer is 150 nm, a gold content is 72 wt%, and overall roughness of the gold-silver alloy bump is 82 nm.

S4, photoresist of the to-be-packaged chip is removed through a photoresist stripper.

S5, a gold seed layer on a silicon substrate of the to-be-packaged chip is removed through an etchant.

S6, a TiW layer on the silicon substrate of the to-be-packaged chip is removed.

S7, annealing is performed on the gold-silver alloy bump, where an annealing temperature is 290°C, annealing time is 30 min, and hardness of the gold-silver alloy bump after annealing is 95 HV.

### Embodiment 3

Grain sizes of gold-silver alloy bumps obtained in Embodiment 1 and Embodiment 2 are measured.

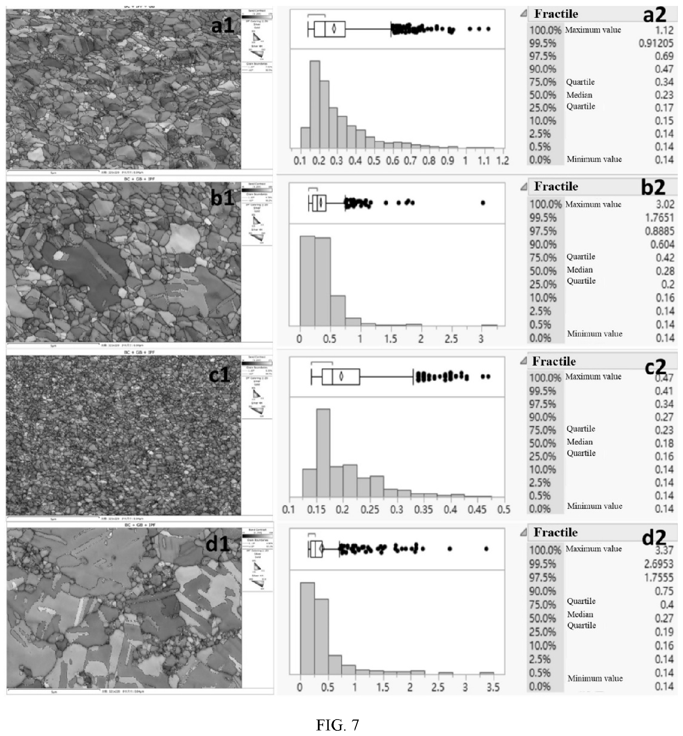

Microstructural analysis is performed on gold-silver alloy plating layers of the gold-silver alloy bumps obtained in Embodiment 1 and Embodiment 2 by EBSD. As shown in FIG. 7, EBSD crystal structure analysis reveals that a1 and a2 are an inverse pole figure (IPF) and a grain distribution map of Embodiment 1 before annealing, and b1 and b2 are an IPF and a grain distribution map of Embodiment 1 after annealing. In addition, c1 and c2 are an IPF and a grain distribution map of Embodiment 2 before annealing, and d1 and d2 are an IPF and a grain distribution map of Embodiment 2 after annealing.

For the gold-silver alloy of Embodiment 1, a median of an equivalent circle diameter of grains before annealing is 0.23 µm, and the equivalent circle diameter of grains corresponding to ±2 standard deviations (in a data range of 2.5% to 97.5%) is 0.14 µm to 0.69 µm. After annealing, a median of an equivalent circle diameter of grains is 0.28 µm, and the equivalent circle diameter of grains corresponding to ±2 standard deviations is 0.14 µm to 0.89 µm. For the gold-silver alloy of Embodiment 2, a median of an equivalent circle diameter of grains before annealing is 0.18 µm, and the equivalent circle diameter of grains corresponding to ±2 standard deviations is 0.14 µm to 0.34 µm. After annealing, a median of an equivalent circle diameter of grains is 0.27 µm, and the equivalent circle diameter of grains corresponding to ±2 standard deviations is 0.14 µm to 1.75 µm. From the above data, it can be seen that increasing a gold content in the plating layers results in a smaller overall grain size, which is consistent with the conclusion that increasing a gold content of a plating layer increases hardness of the plating layer. By comparing grain sizes before and after annealing, it can be seen that a proportion of larger grains in the plating layer is higher after annealing. Compared with the patent CN104099653B with an average grain diameter of 0.7 µm to 0.8 µm and a standard deviation of 0.2 µm to 0.4 µm, it can be seen that the method of the present disclosure may fabricate a gold-silver alloy with smaller grains and a more uniform grain distribution. In addition, from a grain distribution (FIG. 2) described in CN104099653B, it can be seen that larger grains account for a higher proportion. However, in the present disclosure, smaller grains account for a higher proportion. In view of this, a significant difference between the patents is shown.

### Embodiment 4

Sulfidation resistance and oxidation resistance of gold-silver alloy bumps having different gold contents are tested.

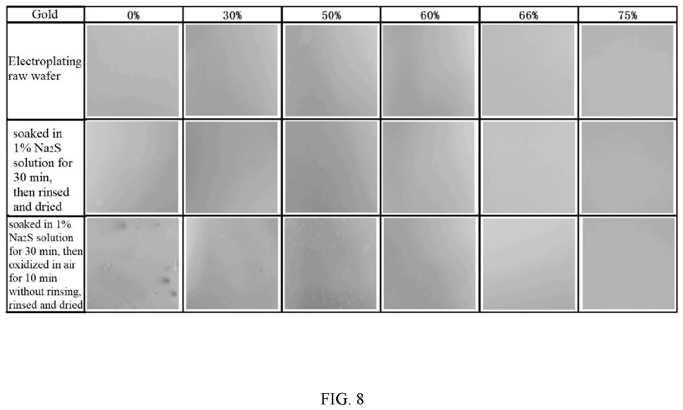

Compared with pure gold, a silver plating layer has inferior sulfidation resistance and oxidation resistance to a gold plating layer. Thus, sulfidation resistance and oxidation resistance of gold-silver alloys having different gold contents are evaluated. A 1% sodium sulfide solution is prepared. An electroplated gold-silver alloy is put into the solution for 30 min, then rinsed with water, and dried. The sulfidation resistance of the plating layer is evaluated by comparing colors of a sample before and after immersion. In the same 1% sodium sulfide solution, the electroplated gold-silver alloy is placed for 1 min, then placed directly in the air for 10 min without rinsing, and rinsed with water and dried. The oxidation resistance of the plating layer is assessed by comparing colors of the sample before and after immersion. As shown in FIG. 8, a pure silver plating layer has poor oxidation resistance and sulfidation resistance, with an obvious color change of the plating layer after immersion in the NaS solution. Sulfidation resistance of a gold-silver plating layer having a gold content of 30 wt% or above is greatly improved, and almost no color change is observed on the plating layer 30 min after immersion in the NaS solution. In terms of the oxidation resistance of the plating layer, in a case of immersion in the NaS solution for 1 min and then air oxidation for 10 min, a plating layer having a gold content of 60% or below still shows a noticeable color change, indicating insufficient oxidation resistance. A color of a plating layer having a gold content of 60% or above is very close to that of pure gold, and oxidation resistance and sulfidation resistance of the plating layer are significantly improved.

Although the implementations of the present disclosure are illustrated and described above, it should be understood that the implementations are illustrative and shall not be construed as limitations to the present disclosure. Those of ordinary skill in the art can make variations, modifications, substitutions and alterations to the above implementations within the scope of the present disclosure without departing from the principle and spirit of the present disclosure. The protection scope of the present disclosure is defined by the claims and their equivalent technical solutions.

## Claims

1. A gold-silver alloy bump, **characterized by** consisting of two gold-silver alloy layers, namely a bonding layer and a protective layer, respectively, wherein a gold content of the bonding layer is 20 wt% to 50 wt%; and a gold content of the protective layer is 60 wt% or above.

2. The gold-silver alloy bump according to claim 1, **characterized in that** an average grain diameter of the gold-silver alloy layers is 0.10 µm to 0.30 µm.

3. The gold-silver alloy bump according to claim 1 or 2, **characterized in that** the gold content of the bonding layer is 20 wt% to 40 wt%.

4. The gold-silver alloy bump according to claim 1 or 2, **characterized in that** the gold content of the bonding layer is 30 wt% to 50 wt%.

5. The gold-silver alloy bump according to claim 1 or 2, **characterized in that** a thickness of the bonding layer is 7 µm to 20 µm, and a thickness of the protective layer is 10 nm to 500 nm.

6. A fabrication method for a gold-silver alloy bump, **characterized by** comprising the following steps:
S1, pretreating a to-be-packaged chip, and preparing an electroplating solution, wherein the electroplating solution comprises the following components: potassium gold cyanide, potassium silver cyanide, potassium pyrophosphate, and hydantoin, with a pH value of 8 to 10;
S2, putting the to-be-packaged chip into the electroplating solution obtained in S1, performing electroplating at a low current density, and fabricating a bonding layer of the gold-silver alloy bump;
S3, using a same electroplating solution and device to perform electroplating at a high current density, and fabricating a protective layer of the gold-silver alloy bump;
S4, removing an auxiliary material of the to-be-packaged chip; and
S5, performing annealing on the gold-silver alloy bump.

7. The fabrication method according to claim 6, **characterized in that** in S2, the low current density is 0.3 A/dm² to 0.6 A/dm², and electroplating time is 30 min to 60 min.

8. The fabrication method according to claim 6, **characterized in that** in S3, the high current density is 1.1 A/dm² to 1.3 A/dm², and electroplating time is 20 s to 40 s.

9. The fabrication method according to claim 6, **characterized in that** in S4, the removing an auxiliary material of the to-be-packaged chip comprises removing photoresist on the to-be-packaged chip through a photoresist stripper, removing a gold seed layer on a silicon substrate of the to-be-packaged chip through an etchant, and removing a titanium-tungsten layer on the silicon substrate of the to-be-packaged chip, wherein the photoresist stripper is N-methylpyrrolidone, the etchant is a thiourea solution, and a substance for removing the titanium-tungsten layer is an H₂O₂ solution.

10. The fabrication method according to claim 6, **characterized in that** in S5, an annealing temperature is 270°C to 300°C, and annealing time is 5 min to 60 min.

11. Application of the gold-silver alloy bump according to any one of claims 1 to 5, **characterized in that** the gold-silver alloy bump is used for packaging of a flip chip.

12. The application according to claim 11, **characterized in that** the flip chip comprises a chip for liquid crystal display, an image sensor, a memory, a microprocessor, or microwave radio frequency.

13. A gold-silver alloy bump fabricated through the fabrication method according to any one of claims 6 to 10.

14. Application of the gold-silver alloy bump according to claim 13, **characterized in that** the gold-silver alloy bump is used for packaging of a flip chip.

15. The application according to claim 14, **characterized in that** the flip chip comprises a chip for liquid crystal display, an image sensor, a memory, a microprocessor, or microwave radio frequency.
